# EUROPÄISCHE PATENTANMELDUNG

(11) **EP 0 980 073 A2**
(43) Veröffentlichungstag der Anmeldung: **16.02.2000**
(21) Anmeldenummer: 99114641.6
(22) Anmeldetag: 27.07.1999
(51) Int. Cl.: G11C 5/00

(54) **Vorrichtung zum Aufbewahren von Speicherkarten**

(30) Priorität: 08.08.1998 DE 19835961
(71) Anmelder: Böhm, Erich, 92521 Schwarzenfeld (DE)
(72) Erfinder: Böhm, Erich, 92521 Schwarzenfeld (DE)
(74) Vertreter: Bergmeier, Werner, Dipl.-Ing.

(57) **Zusammenfassung**

In einer Vorrichtung zum Aufbewahren von Speicherkarten (14), insbesondere Multimeda-Cards, sind Führungen zur Aufnahme wenigstens einer, vorzugsweise mehrerer Speicherkarten (14) in der Vorrichtung (1) vorgesehen.

## Beschreibung

Die Erfindung betrifft eine Vorrichtung zum Aufbewahren von Speicherkarten.

Es ist bekannt, daß sogenannte Multimedia-Cards als Speichermedium beispielsweise für Audio-Player verwendet werden. Diese Speicherkarten weisen Speichereinrichtungen mit einer hohen Speicherdichte auf. Auf Grund ihrer geringen Größe und ihres geringen Gewichtes eignen sich diese Speicherkarten für den mobilen Einsatz in Audio-Playern sehr gut. Außerdem verfügt jeder Nutzer des Players im allgemeinen über so viele Speicherkarten, auf denen beispielsweise Musik gespeichert ist, daß er nur unzureichend den Überblick über die von ihm verfügbaren Karten behalten kann. Durch die geringe Größe der Speicherkarten ist ein Transport der Speicherkarten oft schwierig. Außerdem ist die Gefahr einer Beschädigung der Speicherkarten während des Transportes oder der Aufbewahrung der Speicherkarten außerhalb des Audio-Players groß.

Aufgabe der Erfindung ist es daher, einen sicheren Transport und eine gute Aufbewahrungsmöglichkeit der Speicherkarten außerhalb des die Karten verwendenden Gerätes zu ermöglichen und darüber hinaus die Übersicht über eine Vielzahl von Speicherkarten zu erzielen.

Diese Aufgabe wird gelöst durch eine Vorrichtung zum Aufbewahren von Speicherkarten, insbesondere Multimedia-Cards, wobei Führungen zur Aufnahme wenigstens einer, vorzugsweise mehrerer Speicherkarten in der Vorrichtung anordenbar sind. Die Führungen können dabei länglich sein und die Speicherkarten an ihrer Außenseite führen. Sie können aber auch beispielsweise als eine Art Noppen ausgebildet sein und in entsprechende, korrespondierende Ausnehmungen in den Speicherkarten oder an den Rändern der Speicherkarten eingreifen. Durch die erfinderische Bauweise gelingt es bei einer vorteilhaften Ausgestaltung mehrere Speicherkarten in einer baulichen Einheit zusammenzufassen. Dies erleichtert einen Transport und verschafft dem Nutzer leicht und schnell einen Überblick über alle zusammengefaßten Speicherkarten. Die Vorrichtung dient somit als Kartenhalter und Schutzvorrichtung beim Transport und bei der Aufbewahrung für derartige Speicherkarten.

Damit die Speicherkarten während des Transportes sich nicht von selbst aus der Vorrichtung lösen, weist die Vorrichtung eine Halteeinrichtung für die Speicherkarten auf Diese Halteeinrichtung kann beispielsweise dadurch realisiert werden, indem die Vorrichtung Ausbuchtungen aufweist, die in Vertiefungen der Speicherkarten funktions- und formkomplementär eingreifen. Die Halteeinrichtung kann auch derart ausgebildet sein, daß die Karte nur mittels einer Verformung, die aber nicht so groß sein darf, daß die Speicherkarte beschädigt wird, aus einer Vertiefung der Vorrichtung genommen, beispielsweise geschoben werden kann. Insgesamt dienen die Halteeinrichtungen dazu, daß die Speicherkarten nicht aus der Vorrichtung ungewollt entweichen können.

Vorzugswürdig ist es ferner, wenn die Vorrichtung Einschubfächer für die Speicherkarten aufweist. Die Einschubfächer werden dabei vorzugsweise durch die Führungen gebildet. Durch das Einschieben der Speicherkarten in die dafür vorgesehenen Fächer wird eine leichte und rasche Befüllung der Vorrichtung und Entnahme der Speicherkarten erreicht.

In einer Weiterbildung der Vorrichtung sind Einschiebesicherungen für die Speicherkarten vorgesehen. Einschiebesicherungen sind im Sinne der Erfindung Einrichtungen, die es ermöglichen, die Speicherkarten nur auf eine bestimmte Weise und Lage in der Vorrichtung anzuordnen. Hierdurch soll verhindert werden, daß die Speicherkarten und damit ihre Speicher unterschiedliche Orientierungen und Lagen einnehmen. Derartige Einschiebesicherungen sorgen dafür, daß die Speicherkarten eine vorbestimmte Ausrichtung in der Vorrichtung einnehmen. Dies kann dadurch geschehen, indem die Speicherkarten derart, beispielsweise asymmetrisch gestaltet sind, daß sie im Zusammenwirken mit den Einschiebesicherungen eine eindeutige Anordnung der Speicherkarten ergeben. Vorteilhafterweise können in einer Ausbildung der Erfindung die Einschiebesicherungen in ihrer Funktion gleichzeitig auch als Fixierungseinrichtungen ausgebildet sein.

Zum Schutz der Kontakte der Speicherkarten ist es vorzugswürdig, wenn die Vorrichtung Schutzeinrichtungen hierfür aufweist. Diese Schutzeinrichtungen können vollständige oder teilweise Abdeckungen der Kontakte durch die erfindungsgemäße Vorrichtung sein. Mittels dieser Schutzeinrichtungen werden die Kontakte bzw. Speicher vor mechanischen und anderen äußeren Einwirkungen geschützt. Die Schutzeinrichtungen können ferner auch Eigenschaften und Funktionen von Einschiebesicherungen und Halteeinrichtungen aufweisen.

In einer vorteilhaften Ausgestaltung der Erfindung weist die Vorrichtung Verbindungselemente auf, um Verbindungen mit weiteren Vorrichtungen zu ermöglichen. Hierdurch werden die einzelnen Vorrichtungen zu einer größeren Einheit zusammengefaßt. Dies erhöht die Übersicht über mehrere Vorrichtungen zur Aufbewahrung von Speicherkarten und erweitert die Anwendungsmöglichkeiten der Vorrichtung. Darüber hinaus lassen sich die Vorrichtungen leichter transportieren. Insgesamt ergibt sich ein höherer Nutzen für den Anwender.

Insbesondere ist es vorzugswürdig, wenn die Vorrichtung im wesentlichen die Breite und/oder Länge einer Kreditkarte aufweist. Auf Grund dieser Gestaltung der Vorrichtung kann deshalb die Vorrichtung in vielen bekannten Aufbewahrungsfächern, wie zum Beispiel Filofax, untergebracht werden. Durch diese Gestaltung gelingt es, daß die Vorrichtung in vielen Brieftaschen, Mappen, Koffern, etc. transportiert werden kann, so daß für die Aufbewahrungsvorrichtung die bisherigen Aufbewahrungsfächer genutzt werden können. Dies erhöht ebenfalls die Anwendungsmöglichkeiten der Vorrichtung.

Um die Speicherkarten vor Verschmutzung zu schützen, weist die Vorrichtung vorteilhafterweise eine Schutzhülle, ein Gehäuse bzw. eine Box auf. Durch die Ausbildung einer derartigen geschlossenen Ummantelung des Kartenhalters können die Speicherkarten nicht nur vor Schmutz sondern auch vor der Einwirkung elektromagnetischer Strahlung, insbesondere Licht, geschützt werden.

In einer weiteren besonders vorteilhaften Ausführungsform ist die Vorrichtung einstückig ausgebildet. Hierdurch ist es möglich, die Vorrichtung günstig anzufertigen, da hierfür nur ein einfaches Herstellungsverfahren erforderlich ist. Bei einer günstigen Gestaltung ist es möglich mit einem einzigen Werkzeug den Kartenhalter beispielsweise aus Kunststoff zu spritzen. Der Kartenhalter ist damit besonders kostengünstig herzustellen.

Eine Feder und ein daran angeordnetes Andrückelement ermöglicht eine besonders feste und sichere Halterung der Speicherkarte indem sie die Speicherkarte insbesondere gegen Verbreiterungen des Einschubfaches drückt.

Ist die Speicherkarte in der Vorrichtung eingeklipst, so kann beispielsweise mit seitlich angeordneten Noppen eine Befestigung und Führung der Speicherkarte auf der Vorrichtung geschaffen sein. Die seitlichen Noppen, welche an mehreren Stellen die Speicherkarte überlappen, bewirken, daß die Speicherkarte zuverlässig gehalten wird. Sie kann aus den Noppenführungen entnommen werden, indem entweder die Vorrichtung eine Öffnung aufweist, durch welche gegen die Haltekraft der Klipse die Speicherkarte durchgedrückt werden kann, oder sie kann eine Eingriffmulde aufweisen, mit welcher die Speicherkarte aus der Klipsführung entnommen werden kann. Die Noppen können entweder seitlich an der Speicherkarte angreifen oder, falls die Speicherkarte eine Durchbrechung, beispielsweise ein kreisrundes Loch aufweist, kann die Klipsführung durch diese Öffnung hindurch in ähnlicher Weise die Speicherkarte halten.

Die Erfindung wird anhand eines Ausführungsbeispiels näher erläutert. es zeigt
- Figur 1: eine perspektivische Draufsicht auf einen erfinderischen Kartenhalter und
- Figur 2: eine perspektivische Unteransicht eines Kartenhalters.

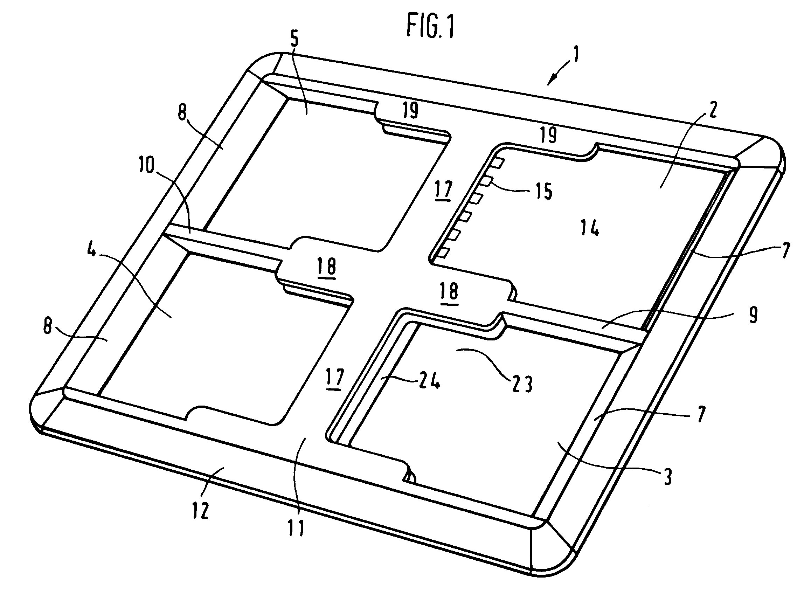

In Figur 1 ist eine Vorrichtung zur Aufbewahrung von Speicherkarten 14 in einer perspektivischen Schrägansicht dargestellt. Die Vorrichtung 1 besitzt eine im wesentlichen rechteckige Form mit einer Umrandung 12, die nach außen hin Abschrägungen aufweist. Hierdurch wird am äußeren Ende der Umrandung 12 eine Verdünnung erzielt, welche das Einschieben der Vorrichtung in Aufbewahrungsbehälter erleichtert.

Die Vorrichtung 1 weist ferner vier Einschubfächer 2, 3, 4, 5 für Speicherkarten 14 auf Diese Einschubfächer 2, 3, 4, 5 sind achsensymmetrisch auf der Vorrichtung 1 angeordnet. Jedes Einschubfach weist an der zur Umrandung 12 benachbarten Stirnseite eine Abschrägung 7, 8 auf. Diese Abschrägungen 7, 8 erleichtern das Ein- und Ausschieben einer Speicherkarte 14 in das und aus dem jeweilige(n) Einschubfach 2, 3, 4, 5.

Die Einschubfächer 2, 3, 4, 5 sind voneinander abgetrennt durch Längsstege 9, 10 und einem Quersteg 11. Der Quersteg 11 weist Verbreiterungen 17 auf, die den Quersteg 11 versteifen. Verbreiterungen 18 und 19 sind auch im Übergang des Querstegs 11 zu den Längsstegen 9 und 10 bzw. der Umrandung 12 ausgebildet. Die Verbreiterungen 17, 18, 19 wirken derart, daß sie die Speicherkarten 14 in den Einschubfächern fixieren gegen ungewolltes Herausfallen, da sie die Speicherkarten 14 an ihren Rändern überlappen. Ein weiterer Nutzen der Verbreiterungen, insbesondere der Verbreiterung 17 besteht darin, daß die Kontakte 15 der Speicherkarten 14 vor Verschmutzung und mechanischen Einwirkungen geschützt werden, wenn sie in eingeschobenem Zustand der Speicherkarte 14 von den Verbreiterungen 17 überdeckt werden.

Die Stege 9 und 11 sowie die Verbreiterung 17, 18 und 19 bilden bei dem vorliegenden Ausführungsbeispiel die Führungen zur Aufnahme der Speicherkarten 14. Durch die Abschrägung 7 bzw. 8 wird die Speicherkarte 14 im Zusammenwirken mit den Verbreiterungen 18 und 19 leicht verbogen, so daß eine feste Einspannung der Speicherkarte 14 in dem Kartenhalter 1 gegeben ist. Die Verbiegung der Speicherkarte 14 darf aber nur sehr gering sein, so daß in jedem Falle sichergestellt ist, daß die Speicherkarte 14 nicht beschädigt wird. Mittels der Abschrägungen 7 bzw. 8 ist es auf einfache Art und Weise möglich, die Speicherkarte 14 wieder aus der Halterung, durch Verschieben in Längsrichtung, zu entfernen. Die Abschrägung 7 bzw. 8 wirkt dabei als Rampe, welche die Speicherkarte 14 aus den Führungen gleiten läßt. In einem anderen Ausführungsbeispiel könnte die Abschrägung 7 bzw. 8 auch durch eine im wesentlichen gerade Kante in der Art der seitlichen Führungen 12, 9 und 10 ausgebildet sein. Hierbei könnte die Unterseite der Vorrichtung 1 eine Öffnung in dem jeweiligen Fach aufweisen, mit welcher beispielsweise durch einen Fingerdruck die Karte 14 aus dem Fach gehoben und durch anschließendes seitliches Verschieben der Speicherkarte 14 aus dem Fach entfernt werden kann.

In einem weiteren, nicht dargestellten Ausführungsbeispiel können die Führungen in den einzelnen Fächern auch derart ausgestaltet sein, daß die Speicherkarten 14 in dem jeweiligen Fach eingeklipst werden. Hierbei können Verbreiterungen in der Art der Verbreiterungen 17, 18 und 19 des Ausführungsbeispiels der Figur 1 Verwendung finden, welche nur eine geringfügige Überlappung der Speicherkarten 14 aufweisen. Es ist damit möglich diese Überlappungen durch eine geringfügige Verformung der Speicherkarten 14 zu überwinden, so daß die Speicherkarten 14 in einer unter den Verbreiterungen liegenden Ausnehmung gehalten werden.

Weisen die Speicherkarten 14 Öffnungen auf, so ist mittels, vorteilhafterweise in die Vorrichtung 1 eingespritzter federnder Laschen eine Fixierung der Speicherkarten 14 in dem Kartenhalter möglich.

Die Verbreiterungen 17, 18 und/oder 19 oder die abgeschrägten Ränder 12 können zur Beschriftung der darin abgelegten Speicherkarten 14 vorgesehen sein. Dies kann mittels direkter Beschriftung oder mittels Klebeflächen für Etiketten vorgesehen sein.

Um die Befestigung der Speicherkarten 14 in dem jeweiligen Einschubfach 2, 3, 4, 5 sicherzustellen, ist eine Feder 23 mit einer Andrückkante 24 vorgesehen. Die Andrückkante 24 ist im Vergleich zur Grundfläche des jeweiligen Einschubfaches 2, 3, 4, 5 erhaben ausgebildet. Dadurch entsteht eine Andrückkraft der eingeschobenen Speicherkarte 14 gegen die Verbreiterung 17, 18 und 19. Die Haltesicherheit der Speicherkarte 14 in der Vorrichtung 1 wird dadurch vergrößert. Außerdem ist eine Verbiegung der Karte 14 nicht oder nur unwesentlich erforderlich, da die Bodenfläche des Einschubfaches 2, 3, 4, 5 durch die Ausbildung als Feder 23 nachgibt und ein bewußtes Entnehmen der Speicherkarte 14 erlaubt.

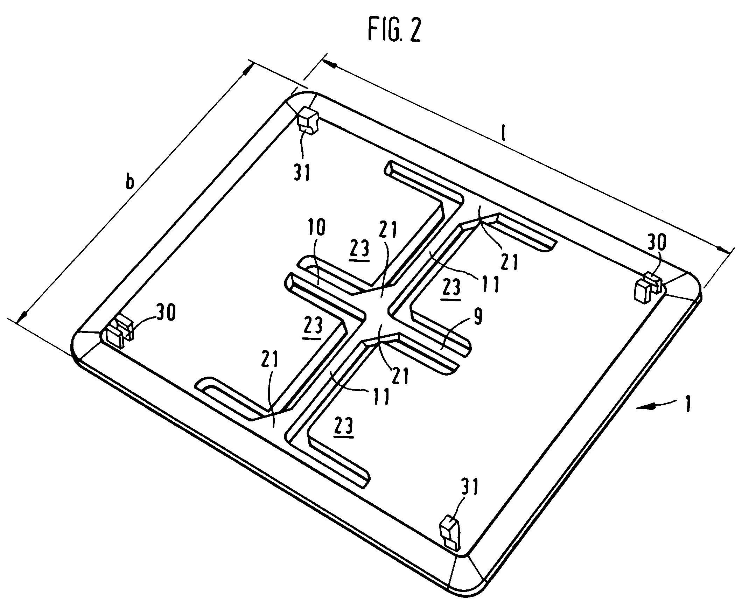

In Figur 2 ist eine Unteransicht eines Kartenhalters 1 dargestellt. Bei dieser Darstellung werden insbesondere die federartige Ausbildung der einzelnen Einschubfächer 2, 3, 4, 5 deutlich. Wie bereits oben beschrieben ist dadurch einerseits die sichere Halterung der Speicherkarte 14 in dem jeweiligen Einschubfach 2, 3, 4, 5 möglich. Andererseits wird damit auf einfache Art und Weise eine Herstellung der Verbreiterungen 17, 18 und 19 ermöglicht, da das Werkzeug von der Unterseite der Vorrichtung 1 her bis auf die Unterseite der Verbreiterung 17, 18 und 19 reicht. Es wird damit einerseits die Feder 23 und andererseits gleichzeitig die Verbreiterung 17, 18 und 19 geschaffen.

Einschiebesicherungen 21 bewirken, daß das jeweilige Einschiebefach entsprechend der Speicherkarte 14 asymmetrisch gestaltet ist. Damit ist es sichergestellt, daß die Speicherkarte 14 jeweils in einer vorgegebenen Position in das Einschubfach 2, 3, 4, 5 eingeschoben wird und somit die Kontakte 15 jeweils in der geschützten Position zu liegen kommen.

Die Vorrichtung 1 kann korrespondierende Verbindungselemente 30 und 31 aufweisen, welche es erlauben, eine zweite gleichartige Vorrichtung 1 mit einer ersten Vorrichtung 1 zu verbinden. Derartige Verbindungselemente 30, 31 können auf jeder Seite der Karte 1 angeordnet sein, so daß eine Vielzahl von Vorrichtungen 1 miteinander zu verbinden sind. Durch die Verbindung mehrerer Vorrichtungen 1 ist gleichzeitig ein gegenseitiger Schutz der Speicherkarten 14, welche in unterschiedlichen Vorrichtungen 1 aufbewahrt sind, gegeben. Sie bilden somit gleichzeitig Schutzhüllen für benachbarte Speicherkarten 14. Selbstverständlich sind allerdings auch eigene Schutzhüllen vorsehbar, welche zum Schutz jeweils einer Vorrichtung 1 vorgesehen sein können.

Selbstverständlich sind die erfindungsgemäßen Vorrichtungen bei den vorteilhaften Maßen von Kreditkarten aber auch bei anderen Abmessungen einsetzbar. Die Maße von Kreditkarten haben üblicherweise eine Länge von etwa 85 mm und eine Breite von etwa 54 mm.

Wenn die Breite und Länge der Vorrichtung 1 in etwa der Breite einer Kreditkarte entspricht, so kann die Vorrichtung auch in den Aufbewahrungsfächern für Kreditkarten, z.B. in Briefmappen, eingesteckt werden. Dies wird durch den nach außen hin verdünnten Rand der Umrandung 12 erleichtert.

Es können derartige Vorrichtungen auch für nur eine Speicherkarte 14 eingesetzt werden, wobei der übrige zur Verfügung stehende Platz auf der Vorrichtung für Beschriftungen, beispielsweise zur Information über den Inhalt der Speicherkarte oder für Werbung verwendet werden kann.

In einem weiteren, nicht dargestellten Ausführungsbeispiel der Erfindung werden die Vorrichtungen ähnlich der Anordnung von Diapositiven in Diamagazinen angeordnet. Es können hierzu in einer vorteilhaften Ausgestaltung Halterungen in dem Magazin und korrespondierende Flächen an den Vorrichtungen vorgesehen sein, die ein Herausfallen der Vorrichtungen aus dem Magazin verhindern.

Wie bereits oben beschrieben, kann neben den dargestellten Führungen und Halterungen für die Speicherkarten auch eine Klipsvorrichtung vorgesehen sein, in welche die Speicherkarten eingeklipst werden. Die Klipse, welche in Form von Noppen ausgestaltet sein können, können entweder seitlich an den Speicherkarten angreifen oder durch Öffnungen, welche in den Speicherkarten vorgesehen sind, greifen. Ein Lösen der Speicherkarte von diesen Klipsführungen kann dadurch erfolgen, daß mit den Fingern unter die Speicherkarten gegriffen wird und diese aus den Führungen gelöst werden. Es kann aber auch in der Vorrichtung vorgesehen sein, daß Öffnungen vorhanden sind, durch welche mittels eines Fingerdrucks die Speicherkarten aus den Klipsführungen gedrückt werden. Ebenfalls ist es möglich und unter den Schutzbereich der Erfindung fallend, daß durch ein Biegen der erfindungsgemäßen Vorrichtung die Speicherkarten aus den Führungen bewegt werden oder leicht aus den Führungen gehoben werden können.

## Patentansprüche

1. Vorrichtung zum Aufbewahren von Speicherkarten (14), insbesondere Multimedia-Cards, welche mit Kontakten (15) versehen sind, wobei die Vorrichtung (1) eine Halteeinrichtung (7,8,9,10,11,17,18,19) zur Aufnahme einer Speicherkarte (14) in der Vorrichtung (1) aufweist, dadurch gekennzeichnet, daß in der Vorrichtung (1) Halteeinrichtungen (7,8,9,10,11,17,18,19) für mehrere Speicherkarten (14) vorgesehen sind, und daß ein Teil der Vorrichtung als eine Feder (23) zum Halten der Speicherkarte (14) in der Halteeinrichtung (7,8,9,10,11,17,18,19) ausgebildet ist.

2. Vorrichtung nach Anspruch 1, dadurch gekennzeichnet, daß zumindest ein Teil der Halteeinrichtung (7,8,9,10,11,17,18,19) als eine Schutzeinrichtung (17) für die Kontakte (15) der Speicherkarte (14) ausgebildet ist.

3. Vorrichtung nach einem oder mehreren der vorangehenden Ansprüche, dadurch gekennzeichnet, daß die Halteeinrichtung (7,8,9,10,11,17, 18,19) ein Einschubfach für die Speicherkarte (14) bildet.

4. Vorrichtung nach einem oder mehreren der vorangehenden Ansprüche, dadurch gekennzeichnet, daß eine Einschiebesicherung (21) für die Speicherkarte (14) vorgesehen ist.

5. Vorrichtung nach einem oder mehreren der vorangehenden Ansprüche, dadurch gekennzeichnet, daß die Vorrichtung im wesentlichen die Breite (b) und/oder Länge (l) einer Kreditkarte aufweist.

6. Vorrichtung nach einem oder mehreren der vorangehenden Ansprüche, dadurch gekennzeichnet, daß die Vorrichtung (1) Verbindungselemente (30, 31) zur Verbindung mit weiteren Vorrichtungen (1) aufweist.

7. Vorrichtung nach einem oder mehreren der vorangehenden Ansprüche, dadurch gekennzeichnet, daß die Vorrichtung (1) eine Schutzhülle aufweist.

8. Vorrichtung nach einem oder mehreren der vorangehenden Ansprüche, dadurch gekennzeichnet, daß die Vorrichtung (1) einstückig ausgebildet ist.

9. Vorrichtung nach einem oder mehreren der vorangehenden Ansprüche, dadurch gekennzeichnet, daß die Feder (23) ein Andrückelement (24) aufweist.

10. Vorrichtung nach einem oder mehreren der vorangehenden Ansprüche, dadurch gekennzeichnet, daß die Vorrichtung (1) Halteflächen zum Halten der Vorrichtung in einem Magazin aufweist.

11. Vorrichtung nach einem oder mehreren der vorangehenden Ansprüche, dadurch gekennzeichnet, daß die Speicherkarte (14) in der Vorrichtung (1) eingeklipst ist.
